# EUROPEAN PATENT APPLICATION

(11) **EP 3 147 945 A1**
(43) Date of publication of application: **29.03.2017**
(21) Application number: 16190371.1
(22) Date of filing: 23.09.2016
(51) Int. Cl.: H01L 27/02, H01L 23/60, H02H 9/04

(54) **ESD DETECTION CIRCUIT**

(30) Priority: 25.09.2015 US 201562232530 P; 02.08.2016 US 201662369787 P; 21.09.2016 US 201615271268
(71) Applicant: MediaTek Inc., Hsin-Chu 300 (TW)
(72) Inventor: Jao, Che-Yuan, 300 Hsinchu City (TW); Huang, Bo-Shih, 300 Hsinchu City (TW)
(74) Representative: Krauns, Christian

(57) **Abstract**

The ESD detection circuit is included in an ESD protected IC including at least one functional circuitry having at least one functional package ball coupled to a first voltage supply and a second voltage supply. The ESD detection circuit includes: at least one ESD package ball, free of being coupled to the functional package ball of the functional circuitry and free of being coupled to the first voltage supply; a plurality of parallel-connected discharge paths, coupled to the ESD package ball and the second voltage supply for discharging an ESD stress event, the parallel-connected discharge paths having different discharge currents from each other; and an ESD indication circuit, coupled to the ESD package ball and the second voltage supply, the ESD indication circuit being in either an open state which is related to ESD pass or in a short state which is related to ESD failed.

## Description

### TECHNICAL FIELD

The disclosure relates in general to an ESD (Electrostatic Discharge) detection circuit and an ESD protected IC applying the same.

### BACKGROUND

Modern high-density integrated circuits (ICs) are known to be vulnerable to damage from the electrostatic discharge (ESD) from a charged body (human or otherwise) as the charged body physically contacts the IC.

Electrostatic discharge phenomena will cause damage to semiconductor devices and affect the normal functioning of integrated circuits (IC).

ESD damage occurs when the amount of charge exceeds the capability of the electrical conduction path through the IC. The typical ESD failure mechanisms include thermal runaway resulting in junction shorting, and dielectric breakdown resulting in gate-junction shorting in the metal-oxide-semiconductor (MOS) context.

An IC may be subjected to a damaging ESD event in the manufacturing process, during assembly, testing, or in the system application. Thus, it is a necessary goal for IC designers, during the design stage, to enhance ESD protection of an IC to increase ESD sensitivity.

### SUMMARY

According to an embodiment, an electrostatic discharge (ESD) detection circuit is provided. The ESD detection circuit is included in an ESD protected IC including at least one functional circuitry having at least one functional package ball coupled to a first voltage supply and a second voltage supply. The ESD detection circuit includes: at least one ESD package ball, free of being coupled to the functional package ball of the functional circuitry and free of being coupled to the first voltage supply; a plurality of parallel-connected discharge paths, coupled to the ESD package ball and the second voltage supply for discharging an ESD stress event, the parallel-connected discharge paths having different discharge currents from each other; and an ESD indication circuit, coupled to the ESD package ball and the second voltage supply, the ESD indication circuit being in either an open state which is related to ESD pass or in a short state which is related to ESD failed.

### BRIEF DESCRIPTION OF THE DRAWINGS

Fig. 1 shows a functional block diagram of an ESD protected IC (integrated circuit) 100 according to one embodiment of the application.
Fig. 2 shows an ESD detection circuit according to an embodiment of the application.
Fig. 3 shows an ESD detection circuit according to another embodiment of the application.
Fig. 4 shows an ESD detection circuit according to another embodiment of the application.
Fig. 5 shows an ESD detection circuit according to another embodiment of the application.

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

### DESCRIPTION OF THE EMBODIMENTS

Technical terms of the disclosure are based on general definition in the technical field of the disclosure. If the disclosure describes or explains one or some terms, definition of the terms is based on the description or explanation of the disclosure. In possible implementation, in the disclosure, the relationship between objects or events includes a direct relationship or an indirect relationship.

Each of the disclosed embodiments has one or more technical features. However, it does not mean that implementation of the disclosure needs every technical feature of any embodiment of the disclosure or combination of the embodiments of the disclosure is prohibited. In other words, in possible implementation, one skilled person in the art would selectively implement part or all technical features of any embodiment of the disclosure or selectively combine part or all technical features of the embodiments of the disclosure.

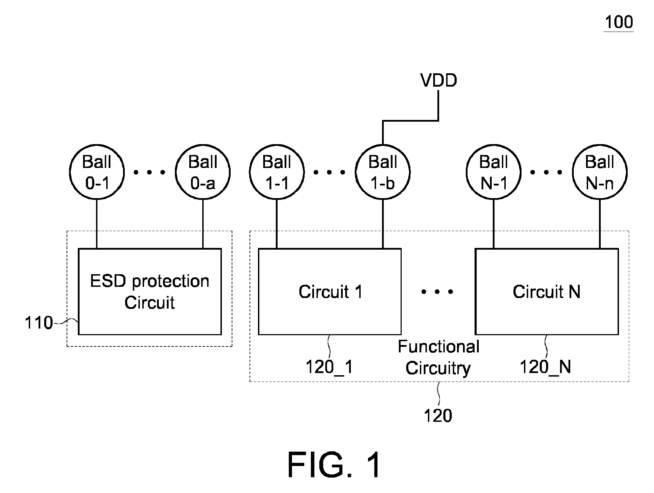

Fig. 1 shows a functional block diagram of an ESD protected IC (integrated circuit) 100 according to one embodiment of the application. As shown in Fig. 1, the ESD protected IC 100 includes an ESD detection circuit 110 and a functional circuitry 120. The ESD detection circuit 110 includes package balls (i.e. ESD package ball) 0-1, ..., and 0-a ("a" being an integer larger than or equal to 1). The functional circuitry 120 includes circuits 120-1, ... 120-N ("N being an integer larger than or equal to 1). The circuit 120-1 of the functional circuitry 120 includes package balls (i.e. functional package balls) 1-1, ... 1-b ("b" being an integer larger than or equal to 1). The circuit 120-N of the functional circuitry 120 includes package ball N-1, ... N-n ("n" being an integer larger than or equal to 1).

As shown in Fig. 1, the package balls 0-1, ..., and 0-a of the ESD detection circuit 110 are free of being coupled to a high voltage supply VDD. On the contrary, the package balls 1-1, ..., and N-n of the ESD functional circuitry 120 are coupled to the high voltage supply VDD, or a signal pin or GND. Further, at least one of the package balls 1-1, ..., and N-n of the ESD functional circuitry 120 is coupled to the high voltage supply VDD, and others of the package balls 1-1, ..., and N-n of the functional circuitry 120 may be coupled to the signal pin or GND. Further, the package balls 0-1, ..., and 0-a of the ESD detection circuit 110 are free of being coupled to the package balls 1-1, ..., and N-n of the functional circuitry 120. But, a low voltage supply (VSS) is shared by the ESD detection circuit 110 and the functional circuitry 120.

In normal operation (i.e. when no ESD stress event occurs), the functional circuitry 120 is normal and the equivalent resistance of the ESD detection circuit 110 is higher than a resistance threshold (for example but not limited by, the normal equivalent resistance of the ESD detection circuit 110 may be several k ohm). That is, if the ESD detection circuit 110 is never stroked by an ESD stress event which is higher than the ESD protection threshold of the ESD detection circuit, the ESD detection circuit 110 is in open state (i.e. ESD pass).

When the ESD stress event occurs, the ESD detection circuit 110 will discharge the ESD stress event to protect the functional circuitry 120. However, if the ESD stress event is above the ESD protection threshold of the ESD detection circuit 110, then the ESD detection circuit 110 will be broken down and thus the equivalent resistance of the ESD detection circuit 110 is very low (for example but not limited by 1 ohm). That is, if the ESD detection circuit 110 has or had been stroked by an ESD stress event which is higher than the ESD protection threshold of the ESD detection circuit, the equivalent resistance of the ESD detection circuit 110 is lower than the resistance threshold and the ESD detection circuit 110 is in short state (i.e. ESD failed).

Thus, by coupling the package ball of the ESD detection circuit 110 to an ESD test pin (not shown) for reading out the equivalent resistance of the ESD detection circuit 110, whether the ESD detection circuit 110 is broken down (due to an ESD stress event higher than the protection threshold) is determined. That is, if the equivalent resistance of the ESD detection circuit 110 is higher than the resistance threshold, the ESD detection circuit 110 is normal. If the equivalent resistance of the ESD detection circuit 110 is lower than the resistance threshold, the ESD detection circuit 110 is/was broken down due to a very high ESD stress event.

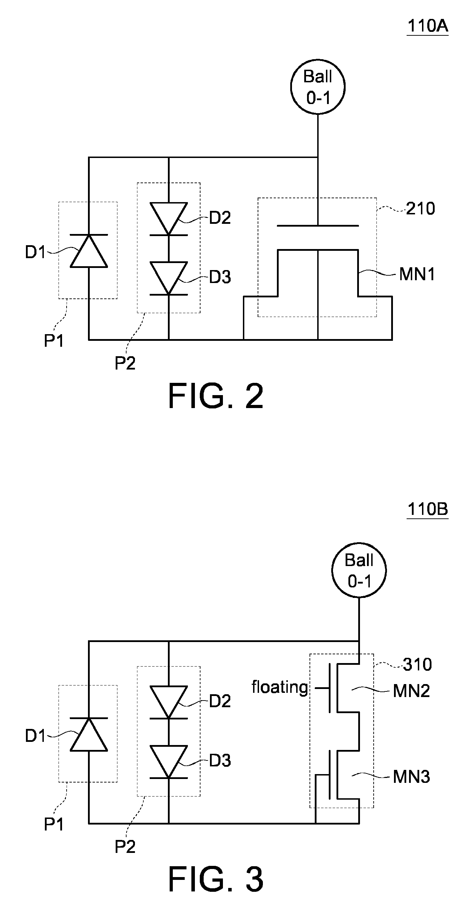

Fig. 2 to Fig. 5 show the ESD detection circuit according to several possible embodiments of the application.

Now refer to Fig. 2. As shown in Fig. 2, the ESD detection circuit 110A according to one embodiment of the application includes discharge paths P1-P2 and an ESD indication circuit 210. The discharge paths P1-P2 are parallel connected.

The discharge path P1 includes a diode D1. The diode D1 is coupled between the package ball 0-1 and the low voltage supply VSS. The discharge path P1 discharges the negative ESD stress voltage at the ESD protected IC.

The discharge path P2 includes series-connected diodes D2 and D3. The diode D2 is coupled between the package ball 0-1 and a terminal of the diode D3. The diode D3 is coupled between a terminal of the diode D2 and the low voltage supply VSS. The discharge path P2 discharges the positive ESD stress voltage at the ESD protected IC. Thus, the discharge paths P1 and P2 have different discharge directions from each other. Further, the discharge paths P1 and P2 have reverse discharge directions.

The ESD indication circuit 210 is implemented by for example but not limited by, an NMOS transistor MN1. The NMOS transistor MN1 includes a first terminal (for example but not limited by a gate terminal) coupled to the package ball 0-1, a second terminal and a third terminal (for example but not limited by a source terminal and a drain terminal) both coupled to the low voltage supply VSS.

In normal, there is no ESD stress event at the ESD protected IC. Thus, in normal, there is no discharge current on the discharge paths P1-P2 and the ESD indication circuit 210 is turned off. Thus, in normal, the ESD indication circuit 210 has a high equivalent resistance.

If an ESD stress event occurred at the ESD protected IC is lower than the protection threshold of the ESD detection circuit 110A, at least one of the discharge paths P1-P2 is conducted to discharge the ESD stress event for protecting the ESD protected IC. However, if the ESD stress event is too high and over the protection threshold of the ESD detection circuit 110A, the NMOS transistor MN1 of the ESD indication circuit 210 will be broken down (even the too high ESD stress event is discharge via the discharge paths P1 or P2) and thus the equivalent resistance of the NMOS transistor MN1 will be very low (i.e. ESD failed).

Therefore, by checking the equivalent resistance of the ESD detection circuit 110A, whether a high ESD stress event has or had been occurred is determined.

Now refer to Fig. 3. As shown in Fig. 3, the ESD detection circuit 110B according to one embodiment of the application includes discharge paths P1-P2 and an ESD indication circuit 310.

The ESD indication circuit 310 is implemented by for example but not limited by, a plurality of cascaded NMOS transistors MN2 and MN3. The NMOS transistor MN2 includes a first terminal (for example but not limited by a gate terminal) which is floated, a second terminal (for example but not limited by a drain terminal) coupled to the package ball 0-1 and a third terminal (for example but not limited by a source terminal) coupled to the NMOS transistor MN3. The NMOS transistor MN3 includes a first terminal (for example but not limited by a gate terminal) coupled to the low voltage supply VSS, a second terminal (for example but not limited by a drain terminal) coupled to the third terminal of the NMOS transistor MN2 and a third terminal (for example but not limited by a source terminal) coupled to the low voltage supply VSS.

In normal, there is no ESD stress event at the ESD protected IC. Thus, in normal, there is no discharge current on the discharge paths P1-P2 and the ESD indication circuit 310 is turned off (i.e. the NMOS transistors MN2 and MN3 are turned off). Thus, in normal, the ESD indication circuit 310 has a high equivalent resistance (i.e. ESD pass).

If the ESD stress event occurred at the ESD protected IC is lower than the protection threshold of the ESD detection circuit 110B, at least one of the discharge paths P1-P2 is conducted to discharge the ESD stress event for protecting the ESD protected IC. However, if the ESD stress event is too high and over the protection threshold of the ESD detection circuit 110B, the NMOS transistors MN2 and MN3 of the ESD indication circuit 310 will be broken down (even the high ESD stress event is discharge via the discharge paths P1 or P2) and thus the drain-source short occurs at both the NMOS transistors MN2 and MN3. Therefore, the equivalent resistance of the NMOS transistors MN2 and MN3 will be very low (i.e. ESD fail) if the ESD stress event is too high and over the protection threshold of the ESD detection circuit 110B.

Therefore, by checking the equivalent resistance of the ESD detection circuit 110B, whether a high ESD stress event has or had been occurred is determined.

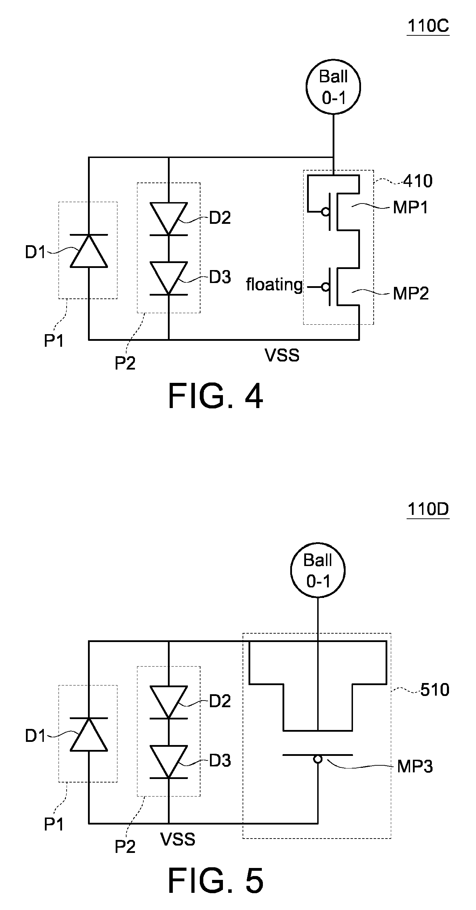

Now refer to Fig. 4. As shown in Fig. 4, the ESD detection circuit 110C according to one embodiment of the application includes discharge paths P1-P2 and an ESD indication circuit 410.

The ESD indication circuit 410 is implemented by for example but not limited by, a plurality of cascaded PMOS transistors MP1 and MP2. The PMOS transistor MP1 includes a first terminal (for example but not limited by a gate terminal) coupled to the package ball 0-1, a second terminal (for example but not limited by a drain terminal) coupled to the PMOS transistor MP3 and a third terminal (for example but not limited by a source terminal) coupled to the package ball 0-1 and the first terminal of the PMOS transistor MP1. The PMOS transistor MP2 includes a first terminal (for example but not limited by a gate terminal) which is floated, a second terminal (for example but not limited by a drain terminal) coupled to the low voltage supply VSS and a third terminal (for example but not limited by a source terminal) coupled to the second terminal of the PMOS transistor MP1.

In normal, there is no ESD stress event at the ESD protected IC. Thus, in normal, there is no discharge current on the discharge paths P1-P2 and the ESD indication circuit 410 is turned off (i.e. the PMOS transistors MP1 and MP2 are turned off). Thus, in normal, the ESD indication circuit 410 has a high equivalent resistance.

If the ESD stress event occurred at the ESD protected IC is lower than the protection threshold of the ESD detection circuit 110C, at least one of the discharge paths P1-P2 is conducted to discharge the ESD stress event for protecting the ESD protected IC. However, if the ESD stress event is too high and over the protection threshold of the ESD detection circuit 110C, the PMOS transistors MP1 and MP2 of the ESD indication circuit 410 will be broken down (even the too high ESD stress event is discharge via the discharge paths P1 or P2) and thus the drain-source short occurs at both the PMOS transistors MP1 and MP2. Therefore, the equivalent resistance of the PMOS transistors MP1 and MP2 will be very low if the ESD stress event is too high and over the protection threshold of the ESD detection circuit 110C.

Therefore, by checking the equivalent resistance of the ESD detection circuit 110C, whether a high ESD stress event has or had been occurred is determined.

Now refer to Fig. 5. As shown in Fig. 5, the ESD detection circuit 110D according to one embodiment of the application includes discharge paths P1-P2 and an ESD indication circuit 510.

The ESD indication circuit 510 is implemented by for example but not limited by, a PMOS transistor MP3. The PMOS transistor MP3 includes a first terminal (for example but not limited by a gate terminal) coupled to the low voltage supply VSS, a second terminal and a third terminal (for example but not limited by a source terminal and a drain terminal) both coupled to the package ball 0-1.

In normal, there is no ESD stress event at the ESD protected IC. Thus, in normal, there is no discharge current on the discharge paths P1-P2 and the ESD indication circuit 510 is turned off. Thus, in normal, the ESD indication circuit 510 has a high equivalent resistance.

If an ESD stress event occurred at the ESD protected IC is lower than the protection threshold of the ESD detection circuit 110D, at least one of the discharge paths P1-P2 is conducted to discharge the ESD stress event for protecting the ESD protected IC. However, if the ESD stress event is too high and over the protection threshold of the ESD detection circuit 110D, the PMOS transistor MP3 of the ESD indication circuit 510 will be broken down (even the too high ESD stress event is discharge via the discharge paths P1 or P2) and thus the equivalent resistance of the PMOS transistor MP3 will be very low.

Therefore, by checking the equivalent resistance of the ESD detection circuit 110D, whether a high ESD stress event has or had been occurred is determined.

In other possible embodiment of the application, the ESD protected IC may include two or more ESD detection circuits whose protection threshold are different from each other. For example but not limited by, the ESD protected IC may include two ESD detection circuits whose protection threshold are 125V and 250V, respectively. Thus, when an ESD stress event of 100V occurs, the two ESD detection circuits both have high equivalent resistance. When an ESD stress event between 125V and 250V (for example but not limited by 200V) occurs, one of the two ESD detection circuits has high equivalent resistance while the other one of the two ESD detection circuits has low equivalent resistance. When an ESD stress event higher 250V occurs, both the two ESD detection circuits have low equivalent resistance.

In embodiments of the application, the ESD protection threshold of the ESD detection circuit may be based on the size of the diodes of the discharge paths and the ratio size of the transistors of the ESD indication circuit. Thus, the ESD protection threshold of the ESD detection circuit may be varied by varying either the size of the diodes of the discharge paths or by varying the ratio size of the transistors of the ESD indication circuit.

In other possible embodiment of the application, the ESD detection circuit may include the discharge paths (i.e. the ESD detection circuit does not include the ESD indication circuit), and the ESD protection threshold thereof is based on the diodes of the discharge paths. Thus, the ESD protection threshold of the ESD detection circuit may be varied by varying the size of the diodes of the discharge paths.

In still other possible embodiment of the application, the ESD detection circuit may include the ESD indication circuit (i.e. the ESD detection circuit does not include the discharge path), and the ESD protection threshold thereof is based on the ratio size of the transistors of the ESD indication circuit. Thus, the ESD protection threshold of the ESD detection circuit may be varied by varying the ratio size of the transistors of the ESD indication circuit.

The embodiments of the application have quick ESD test ability because whether the ESD test is passed or failed is determined by checking the equivalent resistance of the ESD detection circuit. Therefore, the embodiments of the application may decrease the ESD failure analysis time cost. Further, the embodiments of the application may be used to improve the ESD protection during IC assembly or testing.

## Claims

1. An electrostatic discharge (ESD) detection circuit (110) in an ESD protected IC (100), the ESD protected IC including at least one functional circuitry (120) having at least one functional package ball (1-b) coupled to a first voltage supply (VDD) and a second voltage supply (VSS), **characterized in** such that the ESD detection circuit including:
at least one ESD package ball (0-1), free of being coupled to the functional package ball of the functional circuitry and free of being coupled to the first voltage supply;
a plurality of parallel-connected discharge paths (P1, P2), coupled to the ESD package ball and the second voltage supply for discharging an ESD stress event, the parallel-connected discharge paths having different discharge currents from each other; and
an ESD indication circuit (210), coupled to the ESD package ball and the second voltage supply, the ESD indication circuit being in either an open state which is related to ESD pass or in a short state which is related to ESD failed.

2. The ESD detection circuit according to claim 1, wherein the first voltage supply is a VDD voltage supply and the second voltage supply is a VSS voltage supply.

3. The ESD detection circuit according to claim 1 or 2, wherein in normal, an equivalent resistance of the ESD indication circuit is higher than a resistance threshold and the ESD detection circuit is in an open state which is related to ESD pass.

4. The ESD detection circuit according to anyone of the claims 1 to 3, wherein
when an ESD stress event occurs, the parallel-connected discharge paths discharge the ESD stress event; and
when the ESD stress event is above an ESD protection threshold of the ESD detection circuit, the ESD indication circuit is broken down and is in a short state which is related to ESD failed.

5. The ESD detection circuit according to anyone of the claims 1 to 4, wherein each the parallel-connected discharge paths includes at least one diode (D1, D2, D3) coupled between the ESD package ball and the second voltage supply.

6. The ESD detection circuit according to anyone of the claims 1 to 5, wherein the ESD indication circuit includes a transistor (MN1) coupled to the package ball and the second voltage supply, and when an ESD stress event above an ESD protection threshold of the ESD detection circuit occurs, the transistor is broken down.

7. The ESD detection circuit according to anyone of the claims 1 to 6, wherein the ESD indication circuit includes at least two transistors (MN2, MN3) coupled to the package ball and the second voltage supply, one of the at least two transistors having a floated gate terminal, and when an ESD stress event above an ESD protection threshold of the ESD detection circuit occurs, the at least two transistors are drain-source short.
